(19) **Europäisches Patentamt / European Patent Office / Office européen des brevets**

(11) **EP 1 671 143 B1**

(12) **EUROPEAN PATENT SPECIFICATION**

(45) Date of publication and mention of the grant of the patent:
**28.09.2011 Bulletin 2011/39**

(51) Int Cl.:
***G01R 31/42*** *(2006.01)*    ***B60L 3/00*** *(2006.01)*

(21) Application number: **04765918.0**

(22) Date of filing: **08.10.2004**

(86) International application number:
**PCT/EP2004/011342**

(87) International publication number:
**WO 2005/038477 (28.04.2005 Gazette 2005/17)**

(54) **METHOD OF AND APPARATUS FOR ONLINE TESTING AN INTERMEDIATE LINK**

VERFAHREN UND VORRICHTUNG ZUM ONLINE-PRÜFEN EINER ZWISCHENVERBINDUNG

PROCEDE ET DISPOSITIF POUR TESTER EN DIRECT UNE LIAISON INTERMEDIAIRE

(84) Designated Contracting States:
**AT BE BG CH CY CZ DE DK EE ES FI FR GB GR HU IE IT LI LU MC NL PL PT RO SE SI SK TR**

(30) Priority: **09.10.2003 GB 0323661**

(43) Date of publication of application:
**21.06.2006 Bulletin 2006/25**

(73) Proprietor: **Bombardier Transportation GmbH 10785 Berlin (DE)**

(72) Inventor: **HÄSE, Peter CH-8610 Uster (CH)**

(74) Representative: **Novagraaf Technologies 122 rue Edouard Vaillant 92593 Levallois-Perret Cedex (FR)**

(56) References cited:
**AT-B- 408 296**    **US-A- 6 134 128**

- **PATENT ABSTRACTS OF JAPAN vol. 0173, no. 95 (M-1451), 23 July 1993 (1993-07-23) & JP 5 076104 A (FUJI ELECTRIC CO LTD), 26 March 1993 (1993-03-26)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to a method for testing electrical components, in particular a method of determining the dynamic behaviour of an intermediate voltage link and the values of its electrical components. It also relates to a device for performing such a test, in particular, a control and detection unit to detect deviations from nominal behaviour or values. Such methods and devices are particularly applicable to the intermediate circuits used in rail vehicle electrical supply networks.

US 6,134, 128 discloses a method and apparatus for protecting a high-performance power converter. The high-performance power converter comprises a mains power converter, which converts an alternating voltage from a mains power supply into a direct voltage and supplies the direct voltage to an intermediate direct voltage circuit. The intermediate direct voltage circuit is equipped with an intermediate circuit capacitor, and includes a second power converter which converts the direct voltage from the intermediate direct voltage circuit into an alternating voltage, whereby each of the mains power converter and the second power converter is set up as a bridge circuit and each contains a number of IGBTs (Insulated Gate Bipolar Transistors) arranged in pairs in abridge arms. Protection against destruction is achieved in that, when a destructive, discharge of the intermediate circuit capacitor via one of the bridge arms, which has become unintentionally continuously conductive, other bridge anus in the power converters are specifically switched through by way of a relief break-through in order to limit the destruction. It describes a system, which protects the high performance power converter of the intermediate link in case of an incidental destructive discharge of one of the bridge arms by switching through at least one of the other bridging arms in order to distribute the load of the discharge over several bridge arms. The intermediate circuit voltage of the intermediate direct voltage circuit is measured continuously, and the other bridge arms are specifically switched through if the intermediate circuit voltage falls below a predefined threshold voltage during normal operation of the high-performance power converter. Accordingly a voltage measuring unit for measuring the intermediate circuit voltage is arranged in the intermediate direct voltage circuit of the high-performance power converter, while comparison means for comparing the measured intermediate circuit voltage with a predefined threshold voltage are connected to the voltage measuring unit. The comparison means are in functional relationship with a controller for the power converters.

A common form of intermediate voltage link is the direct current DC electrical connection between an AC/DC converter and a DC/AC converter. Such an arrangement may be used in the supply of electrical power to an electrical rail vehicle. In such cases, the first converter may be connected via a single-phase transformer to receive electrical power from e.g. the overhead supply line. This converter is referred to as the line converter. A frequently used form of line converter is the four-quadrant-converter. The second converter is coupled to the motor or motors of the electrical vehicle and is referred to as the motor converter or drive converter. The drive converter may be a multi-phase device.

DC intermediate voltage links for rail vehicle applications generally consist of a main capacitor and a filter. The task of the main capacitor is to store energy and to thereby smoothen the intermediate link voltage. The main capacitor is usually chosen to be as big as possible within the weight limitations of the unit. The task of the filter is to suppress energy pulsations caused by the single phase feeding of the line converter. It may consist of a second capacitor in series with a coil. Other components may also be included according to the intended functions and restrictions placed on the operation of the intermediate link. Such components may include a brake resistor and brake chopper or other form of voltage limiter.

It is important for the proper functioning of most systems that all elements and components operate as close as possible to their nominal values. In the case of rail transport, the rail networks impose stringent requirements regarding line harmonics generated by individual vehicles and propagated onto the supply network. Such harmonics may interfere with signalling on the network or, in worst cases, may cause stoppages of the rail vehicles on that section of the network. It is very difficult to meet such stringent requirements if the elements of the intermediate link are operating outside their nominal range. For this reason, it is useful to be able to detect failures as soon as possible in order to take countermeasures.

At present, different solutions are used to supervise the line harmonics but no special tests are available whereby the integrity and functioning of the intermediate link can be determined during operation thereof. In particular, although it is possible to monitor line harmonics, it is difficult to identify the source of such disruption. It has therefore become desirable to provide a method of testing the integrity of electrical components in an intermediate voltage link between a primary circuit and a secondary circuit.

In the context of the present invention, it has been found that by analysing a transfer function $G(j\omega)$ between the input $I_d$ (or even output $I_a$) current of a DC intermediate link and it's voltage $U_d$

$$G(j\omega) = U_d(j\omega)/I_d(j\omega)$$

or

$$G(j\omega) = U_d(j\omega)/I_a(j\omega)$$

it can be shown that a phase jump occurs at a frequency approximately 2.5 times the net frequency. This means that the phase between input (current) and output (voltage) changes rapidly between + 90 deg and - 90 deg.

If the values of any of the components forming the intermediate circuit, i.e. the main capacitor, filter capacitor or the filter coil, have changed, the phase jump may occur at or over a different frequency. In particular it has been found that, in the case of a decrease in the value of any of these components, the frequency at which the phase jump takes place increases and vice versa. Furthermore, the capacitance of the main capacitor influences primarily only the descending slope of the phase curve. In other cases, changes to the filter elements influence both the descending and the ascending parts of the phase curve.

According to the present invention there is provided a method of testing the integrity of electrical components in the intermediate voltage link between an electrical supply circuit and the drive circuit of an electrical vehicle according to claim 1.

To execute the test, the intermediate link may be excited (loaded or unloaded) for a short time - for example 10 s - by a harmonic excitation. The frequency of that excitation is close to the point where the phase jump occurs and can be pre-calculated with the basic knowledge of an electrical engineer. The phase shift between the load current and the link voltage is measured. The result will be compared with the expected (pre-calculated) value. The deviation may be checked and, in such cases where it exceeds a defined limit, a specified action will be triggered, e.g. a warning to the operator or shut down of the converter(s).

The loading/unloading of the intermediate link may be provided by one of the converters or by the brake chopper/voltage limiter. In order to avoid any interference with the line converter control it is preferable for the test to be executed in the so-called "pre-charged" state of the intermediate link. That means that the line converter is not operating. In such cases, the whole test may preferably be integrated into the starting procedure. Preferably, in such cases, the test could be performed using the brake chopper as the source of the periodic signal by switching it periodically to dissipate energy through the brake resistor.

Alternatively, the method may be executed periodically during operation of the vehicle. In such cases, the signal may be provided via the drive converter as a marginal signal over the existing drive signal. Because the frequency of the test signal is substantially higher than the existing signal (e.g. 2.5 times higher) but with magnitude less than 10% of the maximum torque, it has little effect on the dynamics of the drive itself. The manner in which this signal is generated may be similar to the way in which adhesion control signals are generated and supplied to the drive converter to detect adhesion conditions between the rail and the wheel.

The frequency of testing may be determined in accordance with the experience of the operator or the operating conditions, for example once a month/week/day, or in response to certain indicators e.g. the detection of excessive line harmonics on the supply network.

The evaluation of the results may be achieved in any one of a number of ways, well known in the art. For similar applications the so-called method of "orthogonal correlation" has been successful and is highly recommended.

The method may be improved by using a stepwise procedure. In a first test the intermediate link is checked in general. For this purpose, the frequency of the excitation may be chosen close to the descending part of the phase relationship at a frequency slightly above the phase jump. If the result shows a deviation from the expected phase shift, a second test may be executed with a frequency in the region of the ascending portion of the phase. If the second test also fails, the components of the filter are out of range, otherwise the main capacitor is out of range. Further tests at other frequencies corresponding to other characteristics of the phase relationship may also be carried out.

According to a further aspect of the present invention, there is provided a detection unit for detecting the failure of components in an intermediate link between two converters according to claim 12.

Preferably, the signal generator is able to generate a number of signals. In particular, it should be able to produce a correlation signal orthogonal to the excitation signal for the purpose of performing orthogonal correlation in the evaluation unit. Furthermore, it is desirable, that the signal generator can produce signals at different frequencies. This allows the detection unit to perform a more complete analysis of the intermediate link by evaluating the system response to excitation signals at different frequencies. The signal generator may also be able to generate signals having different waveforms. The most convenient signal for many purposes is the sinusoidal waveform but it is also desirable that the signal generator can produce other waveforms such as square, trapezoidal or triangular waves.

An embodiment of the present invention will now be described, by way of example only, having reference to the accompanying figures, in which:

Figure 1 is a representative circuit diagram for the DC intermediate voltage link between the line converter and the motor converter of a rail vehicle;

Figure 2 is a Bode diagram of the phase shift and magnitude of the transfer function of input current and input voltage for the intermediate voltage link shown in Figure 1;

Figure 3 is a block diagram of an intermediate link including a detection unit according to the present invention;

Figure 4 is a similar Bode diagram to Figure 2 illustrating a failure of the main capacitor;

Figure 5 is a similar Bode diagram to Figure 2 illustrating a failure of the filter capacitor; and

Figure 6 is a similar Bode diagram to Figure 4, illustrating a typical intermediate link transfer function with voltage control.

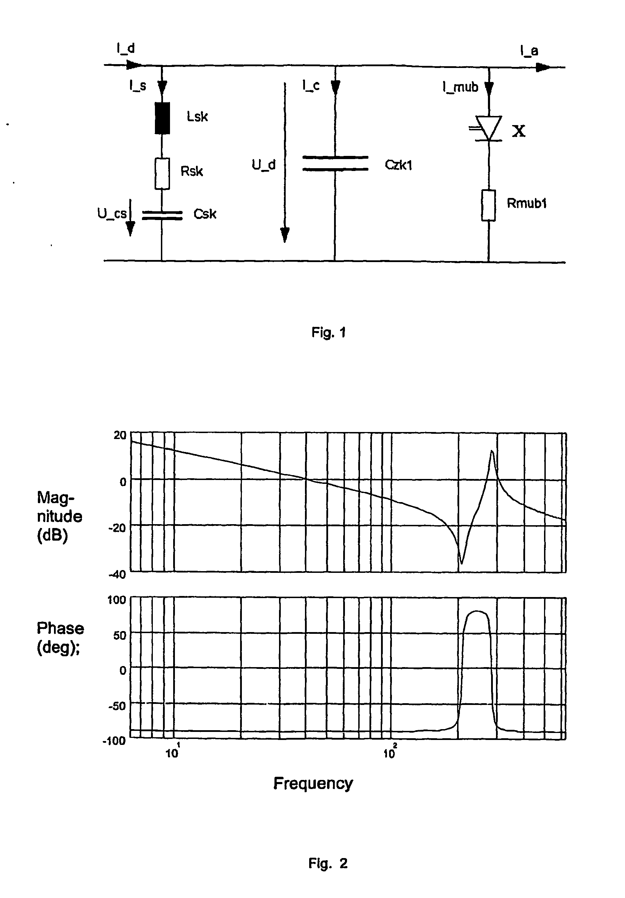

According to the embodiment as disclosed in Figure 1, there is shown a representative circuit diagram of a DC intermediate voltage link between the line converter and the motor converter of a rail vehicle. The intermediate voltage links consists of a main capacitor $C_{zk1}$ and a filter. The task of the capacitor is to store energy and to thereby smoothen the intermediate link voltage $U_d$. The task of the filter is to suppress the energy pulsation caused by the single phase feeding of the line converter. The presence of such pulsations is detrimental to operation of the converters and can lead to the propagation of unwanted harmonic signals back onto the supply network. The filter consists of a second capacitor $C_{sk}$ and a coil $L_{sk}$. For the purpose of energy supply to a rail vehicle from a supply network, the values of these components are generally chosen to fulfil the following equations:

$$f_N = 1/4\pi * \sqrt{1/(L_{sk} * C_{sk})},$$

where

$f_N$ ... line (supply network) frequency
$L_{sk}$ ... inductance of the coil
$C_{sk}$ ... capacitance of the capacitor.

Additionally, a brake resistor $R_{mub1}$ and brake chopper X may be present in the form of a so-called voltage limiter. Such a voltage limiter allows for resistive braking by dissipation through the resistor $R_{mub1}$ under the control of the brake chopper X when excessive regeneration through the drive converter causes excess voltage in the intermediate link. For other applications, other intermediate link configurations using components of different values may be necessary.

The intermediate voltage link may be represented by a transfer function relating the input current $I_d$ (or output current $I_a$) to the intermediate link voltage $U_d$ for different frequencies $j\omega$.

$$G(j\omega) = U_d(j\omega)/I_d(j\omega)$$

or

$$G(j\omega) = U_d(j\omega)/I_a(j\omega).$$

Figure 2 shows a Bode diagram of the transfer function $G(j\omega)$ of input current $I_d$ and voltage $U_d$ for the intermediate voltage link shown in Figure 1. The Bode diagram represents in the lower section, the phase shift of the input current $I_d$ with respect to the voltage $U_d$ over a frequency range and in the upper section, the magnitude of the transfer function expressed on a decibel scale. By analysis of the transfer function $G(j\omega)$ it can be shown that a phase jump occurs at a frequency approximately 2.5 times the net frequency for which the components are rated (which in the illustrated example is 16.7 Hz). At frequencies below the phase jump in the normal operating range of the link, the input current $I_d$ leads the voltage $U_d$ by 90 deg. The same applies for frequencies above the phase jump. In the region of the phase jump, however, the phase relationship between input (current) and output (voltage) changes rapidly between + 90 deg and - 90 deg and, over this narrow frequency range, the input current lags the voltage $U_d$ by 90 deg. Additionally, in the region of the phase jump, it may be noted that the magnitude of the transfer function changes significantly.

If the rating value of the main capacitor, filter capacitor or filter coil should change for any reason, the phase jump will occur at a different frequency. This will be demonstrated by the examples given below. It can be shown that, in the case of a decrease of the value of any of the above mentioned components, the frequency at which the phase jump occurs increases and vice versa. Furthermore, the capacitance of the main capacitor $C_{zk1}$ influences only the descending portion of the phase relationship. Changes to the rating of the filter components influence both the descending and the ascending portions of the phase relationship.

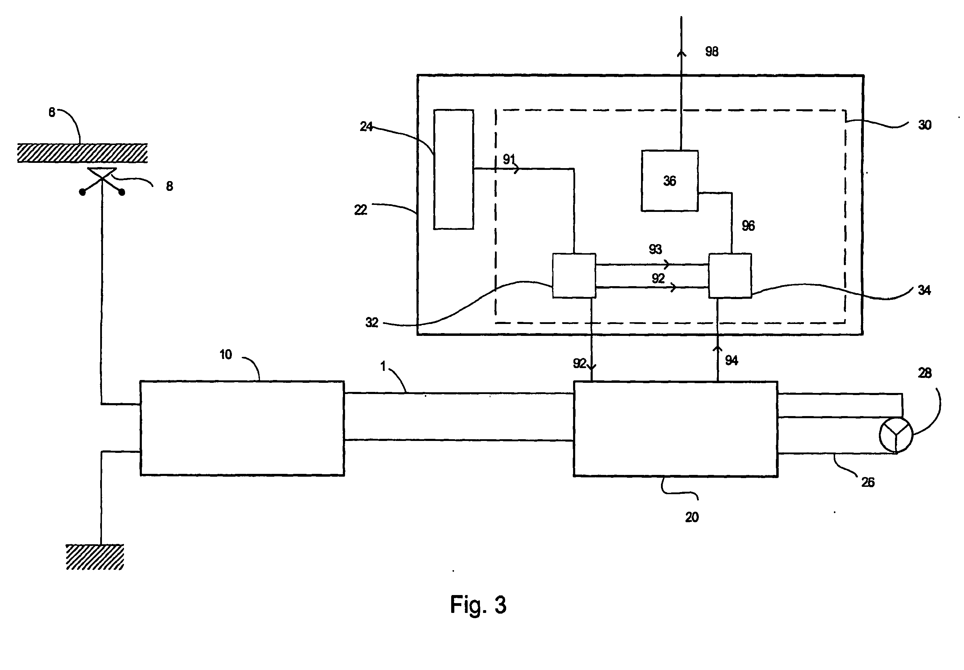

Figure 3 shows a schematic block diagram of an intermediate voltage link 1 between a line converter 10 and a drive converter 20. The line converter 10 is provided with a single-phase power supply via a current collector (pantograph) 8 from a supply network 6. The drive converter 20 supplies current via a 3-phase supply 26 to a motor 28. The drive converter 20 is controlled by a drive converter control unit 22 including an activating unit 24. A detection unit 30 according to one embodiment of the present invention is schematically illustrated as forming part of the drive converter control unit 22. The detection unit comprises a signal generator 32, an evaluation unit 34 and a comparator 36.

The operation of the detection unit 30 for testing the integrity of the intermediate link according to the present invention will now be explained by way of example, with reference to Figures 3 to 5. The activation unit 24 emits an activation signal 91 to indicate the start of a detection procedure to execute the test of the intermediate link 1. The signal generator produces a test signal 92 in the form of a harmonic excitation, which is provided (loaded or unloaded) to the intermediate circuit 1 via the drive converter for a short time - for example 10 s. The frequency of the excitation test signal 92 is chosen to be close to the point where a phase jump is expected to occur. This can be pre-calculated with the basic knowledge of an electrical engineer on the basis of the rated values of the electrical components. A response signal 94 is provided to the evaluation unit 34 representing the voltage response of the intermediate link 1 to the applied excitation. Concurrently to the generation of the test signal 92, the signal generator 32 also produces a correlation signal 93. The correlation signal 93 is produced to have exactly the same frequency and magnitude as the test signal 92 but is orthogonal thereto, i.e. it is shifted by 90 deg. Both the correlation signal 93 and the test signal 92 are supplied directly to the evaluation unit 34 for the purpose of orthogonal correlation as will be described below. The evaluation unit 34 evaluates the phase shift between the load current as applied to the intermediate link by the test signal 92 and the link voltage response signal 94. The evaluation unit 34 produces as an output a phase shift signal 96. The phase shift signal 96 is supplied to the comparator 36 where it is compared with the expected value as calculated. The expected value may be stored in the comparator or supplied thereto from another memory device (not shown). The deviation of the phase shift signal 96 from the expected value is checked and, in the case that it exceeds a defined limit, an alarm signal 98 is triggered, e.g. as a warning to the operator or as a signal to shut down the converter(s).

The evaluation of the signals 92, 94 may be done in any one of a number of well-known ways. A particularly advantageous method is the so-called method of "orthogonal correlation", which has proved successful for similar evaluations. This method is extensively described in EP 0 826 549 A1 and involves providing first T and second $T_A$ harmonic signals for which it is desired to calculate the phase difference. A further correlation signal $T_{Ph}$ is generated with 90 deg phase shift with respect to T. The phase shift of T with respect to $T_A$ is determined by first forming the product of both signals with the correlation signal and taking the time-dependent mean of these products. The arctan of the quotient of the mean of the products represents the phase shift.

$$\varphi = \arctan \left| T.T_{Ph} \right| / \left| T_A.T_{Ph} \right|$$

The test signal 92 may be a small percentage of the signal present on the intermediate link 1. For a DC intermediate link operating at 2800 V, a signal having an amplitude of 100 V may be sufficient.

Example 1: Failure of the Main Capacitor

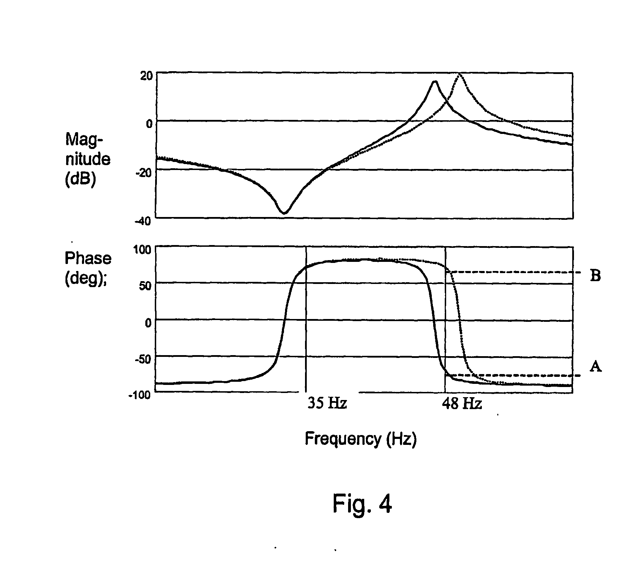

For an intermediate voltage link with a main capacitance $C_{zk1}$ of 12 mF, the line frequency is 16,7 Hz. According to these values, the filter inductance $L_{sk}$ should be 2.02 mH and the filter capacitance $C_{sk}$ 11.25 mF. The transfer function assuming the nominal values of all these components is shown by the full line in Figure 4.

In this first example, it will be assumed that the main capacitance has dropped to 20 % lower than it's nominal value. The actual transfer function is shown by the dotted line in Figure 4. By choosing an excitation test signal 92 having a frequency of 48 Hz, the expected (nominal) phase shift is - 74 deg (point A). In case of the mentioned failure the phase shift will in fact be > 60 deg as shown in the figure at point B.

Example 2 : Failure of the Filter Capacitor

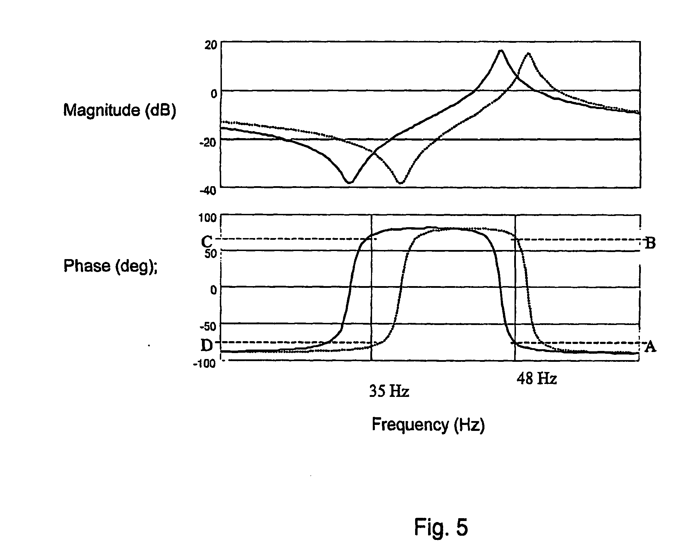

Using the same intermediate link voltage it will be assumed instead that the value of the filter capacitor $C_{sk}$ has dropped to 20 % less than it's nominal value. A first test will be executed with a harmonic excitation test signal 92 of 48 Hz again. As a result the failure will be detected by obtaining a similar phase shift as in the first example. For more detailed information a second test may be executed with a second excitation test signal 92 of 35 Hz. In the case of a failure-free intermediate link or even in the case of a failure in the main capacitor $C_{zkl}$, the phase shift is > 70 deg as shown by point C. In the case of failure in the filter capacitor $C_{sk}$, the phase shift is < - 75 deg as shown by point D in figure 5. The use of a two-step procedure thus permits the determination of further details concerning the failure.

Many other variations of the present invention are also possible. In particular, while reference has been made to sinusoidal excitation test signals, any other kind of harmonic excitation is also possible including, but not limited to rectangular, triangular and trapezoidal functions. The loading/unloading of the intermediate link may be provided by one of the converters or by the brake chopper/voltage limiter. In order to avoid any interference with the line converter control it is preferable to execute the test in the so-called "pre-charged" state of the intermediate link when the line converter is not operating. In such situations, it may be desirable to integrate the whole test into the drive start-up procedure.

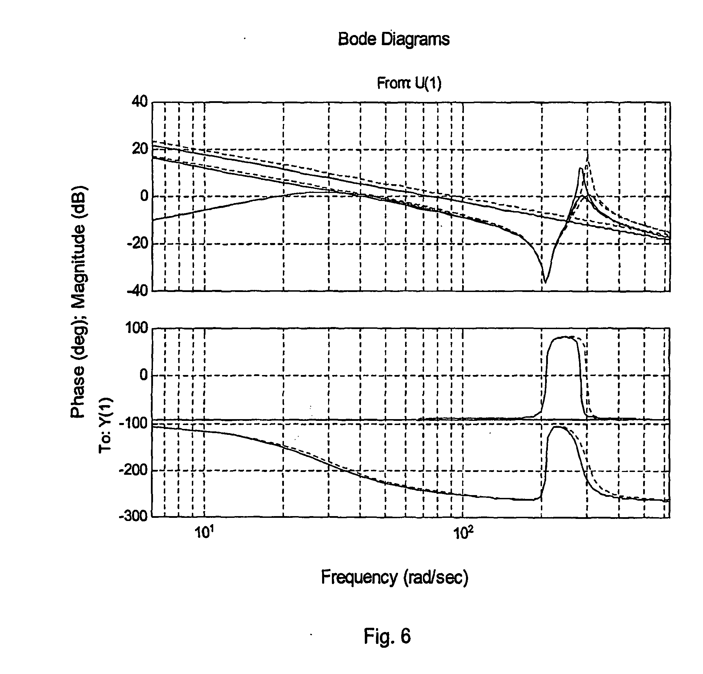

The transfer functions illustrated in Figures 2, 4 and 5 are somewhat idealised versions of the true functions. Figure 6 illustrates how the true transfer may appear. In particular, for a voltage controlled intermediate link, the phase jump is less marked than in the cases of the earlier figures, making detection more difficult. In such circumstances, it may be desirable to take action to disenable the voltage regulation of the intermediate circuit during the testing phase.

The above examples have been described in relation to a 16.7 Hz line frequency with testing at 48 Hz. For rail systems operating at higher frequencies, e.g. 60 Hz, the frequencies of the test signals must also increase. For higher frequencies where it may not be desirable to use IGBT type drive converters to generate test signals an alternative may be to use the brake chopper X to periodically switch the brake resistor $R_{mub1}$ on and off. Such brake choppers can presently operate at 250 Hz and above.

Other alternative methods of providing the test signal to the intermediate link may also be considered. These may include the use of separate test circuits for connection to the link while it is powered down, or of other dedicated circuits. Such alternatives are not however considered as practical as the above-described integrated on-line tests. Furthermore, while reference has been made to harmonic test signals, it is also within the scope of the present invention that the system response to an individual pulse may also be analysed to determine the integrity of the system components.

While the above description has described a test for an intermediate circuit from an AC line voltage, the principles of the present invention may also be applied to DC voltage supplies directly to the intermediate circuit In such cases, the distance between the rail vehicle and the nearest electricity substation will need to be included in the circuit analysis to compensate for the varying impedance of the combined circuit formed by the intermediate link and the DC supply circuit.

While the above examples illustrate preferred examples of the present invention it is noted that various other arrangements may also be considered which fall within the scope of the present invention as defined by the appended claims.

## Claims

1. A method of testing the integrity of electrical components in an intermediate voltage link (1) between an electrical supply circuit (10) and the drive circuit (20) of an electrical vehicle, wherein the intermediate voltage link has a nominal transfer function exhibiting a phase jump at a frequency $\omega$, the method comprising:

   generating a first test signal (92) at a predefined magnitude and frequency, the frequency being close to $\omega$, and applying the test signal to the intermediate link (1) ;
   measuring a system response (94) to the test signal and determining a phase shift of the system response to the excitation signal;
   comparing the phase shift (96) with an expected phase shift; and,
   in the event of a deviation between the phase shift and the expected phase shift, generating an error signal (98).

2. The method according to claim 1, wherein the transfer function is the relationship between input voltage and input current and wherein the step of measuring comprises measuring the phase shift of the input current with respect to the input voltage.

3. The method according to claim 2, wherein the phase shift is determined by orthogonal correlation with a further signal generated with 90 deg phase shift with respect to the test signal.

4. The method according to any of claims 1 to 3, further comprising repeating the steps of the method using a second test signal having a frequency close to $\omega$ but different from the first test signal.

5. The method according to claim 4, wherein the steps of the method are repeated using the second test signal only if the first test causes an error signal to be generated.

6. The method according to any of claims 1 to 5, wherein the first test signal has a frequency higher than $\omega$ corresponding to a trailing edge of the phase jump.

7. The method according to any of claims 4 to 6, wherein the second test signal has a frequency lower than $\omega$ corresponding to a leading edge of the phase jump.

8. The method according to any preceding claim, wherein the test signal is a sinusoidal signal.

9. The method according to any preceding claim, wherein the intermediate voltage link comprises a brake chopper and the test signal is provided to the intermediate voltage link by the brake chopper.

10. The method according to any preceding claim, wherein the steps of the method are performed during a pre-charged state of the intermediate voltage link, during a start-up procedure.

11. The method according to any preceding claim, wherein the steps of the method are performed periodically during operation of the intermediate voltage link.

12. A detection unit (30) for detecting the failure of electrical components in an intermediate voltage link (1) between a first converter (10) and a second converter (20), the intermediate voltage link (1) having a nominal transfer function exhibiting a phase jump at a frequency $\omega$, the detection unit (30) comprising:

   a signal generator (32) with a first output for generating an excitation signal (92) at a predefined magnitude and frequency close to $\omega$ and applying the excitation signal (92) to the intermediate voltage link;
   an evaluation unit for (34) determining a phase shift of the system response to the excitation signal (92); and

a comparator (36), adapted to compare the phase shift determined by the evaluation unit (34) with an expected value and adapted to generate a warning signal (98) if the result is outside an allowed range.

13. The detection unit (30) according to claim 12, wherein the signal generator has a second output for generating a second signal with a phase angle of 90° relative to the first signal.

14. The detection unit (30) according to claim 13, wherein the evaluation unit (34) performs orthogonal correlation on the system response using the second signal.

15. An intermediate voltage link assembly comprising a first converter (10), a second converter (20) and an intermediate voltage link (1) between the first converter (10) and the second converter (20), the intermediate voltage link having a nominal transfer function exhibiting a phase jump at a frequency ω, comprising a detection unit (30) according to any one of claims 12 to 14, wherein at least one of the first and second converters (10, 20) comprises a converter control unit (22) and the detection unit (30) forms part of the converter control unit (22).

16. An intermediate voltage link (1) assembly comprising a first converter (10), a second converter (20) and an intermediate voltage link (1) between the first converter (10) and the second converter (20), comprising a detection unit, according to any one of claims 12 to 14, and in particular an assembly according to claim 15, wherein the intermediate link comprises a brake chopper unit and the detection unit forms part of the brake chopper control unit.

17. An intermediate voltage link (1) assembly comprising a first converter (10), a second converter (20) and an intermediate voltage link (1) between the first converter (10) and the second converter (20), comprising a detection unit, according to any one of claims 12 to 14, and in particular an assembly according to claim 15 or claim 16, wherein the first converter (10) is a four-quadrant converter.

**Patentansprüche**

1. Verfahren zum Testen der Integrität von elektrischen Komponenten in einem Spannungszwischenkreis (1) zwischen einer elektrischen Versorgungsschaltung (10) und der Antriebsschaltung (20) eines Elektrofahrzeugs, wobei der Spannungszwischenkreis eine nominelle Übertragungsfunktion mit einem Phasensprung bei einer Frequenz w aufweist, wobei das Verfahren Folgendes umfasst:

Erzeugen eines ersten Testsignals (92) mit einer vordefinierten Größe und Frequenz, wobei die Frequenz nahe w liegt, und Anlegen des Testsignals an den Zwischenkreis (1);
Messen einer Systemreaktion (94) auf das Testsignal und Ermitteln einer Phasenverschiebung der Systemreaktion auf das Anregungssignal;
Vergleichen der Phasenverschiebung (96) mit einer erwarteten Phasenverschiebung; und
Erzeugen eines Fehlersignals (98) im Falle einer Abweichung zwischen der Phasenverschiebung und der erwarteten Phasenverschiebung,.

2. Verfahren nach Anspruch 1, wobei die Übertragungsfunktion das Verhältnis zwischen Eingangsspannung und Eingangsstrom ist und wobei der Messschritt das Messen der Phasenverschiebung des Eingangsstroms mit Bezug auf die Eingangsspannung beinhaltet.

3. Verfahren nach Anspruch 2, wobei die Phasenverschiebung durch orthogonale Korrelation mit einem weiteren Signal ermittelt wird, das mit 90 Grad Phasenverschiebung mit Bezug auf das Testsignal erzeugt wird.

4. Verfahren nach einem der Ansprüche 1 bis 3, das ferner das Wiederholen der Schritte des Verfahrens mit einem zweiten Testsignal umfasst, das eine Frequenz nahe w aufweist aber vom ersten Testsignal verschieden ist.

5. Verfahren nach Anspruch 4, wobei die Schritte des Verfahrens mit dem zweiten Testsignal nur dann wiederholt werden, wenn der erste Test das Erzeugen eines Fehlersignals verursacht.

6. Verfahren nach einem der Ansprüche 1 bis 5, wobei das erste Testsignal entsprechend einer nachlaufenden Flanke des Phasensprungs eine Frequenz oberhalb von w aufweist.

7. Verfahren nach einem der Ansprüche 4 bis 6, wobei das zweite Testsignal entsprechend einer vorlaufenden Flanke des Phasensprungs eine Frequenz unterhalb von w aufweist.

8. Verfahren nach einem der vorherigen Ansprüche, wobei das Testsignal ein sinusförmiges Signal ist.

9. Verfahren nach einem der vorherigen Ansprüche, wobei der Spannungszwischenkreis einen Bremsstromrichter umfasst und das Testsignal von dem Bremsstromrichter an den Spannungszwischenkreis angelegt wird.

**EP 1 671 143 B1**

**10.** Verfahren nach einem der vorherigen Ansprüche, wobei die Schritte des Verfahrens in einem vorgespannten Zustand des Spannungszwischenkreises bei einem Startvorgang ausgeführt werden.

**11.** Verfahren nach einem der vorherigen Ansprüche, wobei die Schritte des Verfahrens periodisch während des Betriebs des Spannungszwischenkreises ausgeführt werden.

**12.** Detektionseinheit (30) zum Erkennen des Ausfalls von elektrischen Komponenten in einem Spannungszwischenkreis (1) zwischen einem ersten Wandler (10) und einem zweiten Wandler (20), wobei der Spannungszwischenkreis (1) eine nominelle Übertragungsfunktion mit einem Phasensprung bei einer Frequenz w aufweist, wobei die Detektionseinheit (30) Folgendes umfasst:

einen Signalgenerator (32) mit einem ersten Ausgang zum Erzeugen eines Anregungssignals (92) mit einer vordefinierten Größe und Frequenz nahe ω und Anlegen des Anregungssignals (92) an den Spannungszwischenkreis; eine Auswerteeinheit (34) zum Ermitteln einer Phasenverschiebung der Systemreaktion auf das Anregungssignal (92); und einen Komparator (36), der dazu ausgebildet ist, die von der Auswerteeinheit (34) ermittelte Phasenverschiebung mit einem erwarteten Wert zu vergleichen, und der dazu ausgebildet ist, ein Warnsignal (98) zu erzeugen, wenn das Ergebnis außerhalb eines zulässigen Bereichs liegt.

**13.** Detektionseinheit (30) nach Anspruch 12, wobei der Signalgenerator einen zweiten Ausgang zum Erzeugen eines zweiten Signals mit einem Phasenwinkel von 90 Grad relativ zum ersten Signal hat.

**14.** Detektionseinheit (30) nach Anspruch 13, wobei die Auswerteeinheit (34) mit dem zweiten Signal eine orthogonale Korrelation an der Systemreaktion durchführt.

**15.** Spannungszwischenkreiseinrichtung (1), welche einen ersten Wandler, einen zweiten Wandler (20) und ein Spannungszwischenkreis zwischen dem ersten Wandler (10) und dem zweiten Wandler (20) aufweist, wobei der Spannungszwischenkreis eine nominelle Übertragungsfunktion mit einem Phasensprung bei einer Frequenz w aufweist, umfassend eine Detektionseinheit (30) nach einem der Ansprüche 12 bis 14, wobei wenigstens einer von dem ersten und dem zweiten Wandler (10, 20) eine Wandlersteuereinheit (22) aufweist und die Detektionseinheit (30) Teil der Wandlersteuereinheit (22) ist.

**16.** Spannungszwischenkreiseinrichtung (1), welche einen ersten Wandler, einen zweiten Wandler (20) und ein Spannungszwischenkreis zwischen dem ersten Wandler (10) und dem zweiten Wandler (20) aufweist, umfassend eine Detektionseinheit nach einem der Ansprüche 12 bis 14, insbesondere Einrichtung nach Anspruch 15, wobei der Zwischenkreis eine Bremsstromrichter-Einheit umfasst und die Detektionseinheit Teil der Bremsstromrichter-Steuereinheit ist.

**17.** Spannungszwischenkreiseinrichtung (1), welche einen ersten Wandler, einen zweiten Wandler (20) und ein Spannungszwischenkreis zwischen dem ersten Wandler (10) und dem zweiten Wandler (20) aufweist, umfassend eine Detektionseinheit nach einem der Ansprüche 12 bis 14, insbesondere Einrichtung nach Anspruch 15 oder Anspruch 16, wobei der erste Wandler (10) ein Vier-Quadranten-Steller ist.

## Revendications

**1.** Procédé d'évaluation de l'intégrité de composants électriques dans une liaison de tension intermédiaire (1) entre un circuit d'alimentation électrique (10) et le circuit de commande (20) d'un véhicule électrique, où la liaison de tension intermédiaire a une fonction de transfert nominale présentant un saut de phase à une fréquence $\omega$, le procédé comprenant les étapes consistant à :

générer un premier signal d'essai (92) à une amplitude et une fréquence prédéfinies, la fréquence étant proche de $\omega$, et appliquer le signal d'essai à la liaison intermédiaire (1) ; mesurer une réponse de système (94) au signal d'essai et déterminer un déphasage de la réponse de système au signal d'excitation ; comparer le déphasage (96) avec un déphasage attendu ; et dans le cas d'un écart entre le déphasage et le déphasage attendu, générer un signal d'erreur (98).

**2.** Procédé selon la revendication 1, dans lequel la fonction de transfert est la relation entre la tension d'entrée et le courant d'entrée et où l'étape de mesure comprend la mesure du déphasage du courant d'entrée par rapport à la tension d'entrée.

**3.** Procédé selon la revendication 2, dans lequel le déphasage est déterminé par corrélation orthogonale avec un signal supplémentaire généré avec un déphasage de 90 degrés par rapport au signal d'essai.

**4.** Procédé selon l'une quelconque des revendications 1 à 3, comprenant en outre la répétition des étapes du procédé à l'aide d'un second signal d'essai ayant une fréquence proche de ω mais différente de celle du premier signal d'essai.

5. Procédé selon la revendication 4, dans lequel les étapes du procédé sont répétées en utilisant le second signal d'essai seulement si le premier essai entraîne la génération d'un signal d'erreur.

6. Procédé selon l'une quelconque des revendications 1 à 5, dans lequel le premier signal d'essai a une fréquence supérieure à ω correspondant au bord de fuite du saut de phase.

7. Procédé selon l'une quelconque des revendications 4 à 6, dans lequel le second signal d'essai a une fréquence inférieure à ω correspondant à un bord d'attaque du saut de phase.

8. Procédé selon l'une quelconque des revendications précédentes, dans lequel le signal d'essai est un signal sinusoïdal.

9. Procédé selon l'une quelconque des revendications précédentes, dans lequel la liaison de tension intermédiaire comprend un hacheur de freinage et le signal d'essai est fourni à la liaison de tension intermédiaire par le hacheur de freinage.

10. Procédé selon l'une quelconque des revendications précédentes, dans lequel les étapes du procédé sont effectuées pendant un état préchargé de la liaison de tension intermédiaire, pendant une procédure de démarrage.

11. Procédé selon l'une quelconque des revendications précédentes, dans lequel les étapes du procédé sont effectuées périodiquement pendant le fonctionnement de la liaison de tension intermédiaire.

12. Unité de détection (30) permettant de détecter la défaillance de composants électriques dans une liaison de tension intermédiaire (1) entre un premier convertisseur (10) et un second convertisseur (20), la liaison de tension intermédiaire (1) ayant une fonction de transfert nominale affichant un saut de phase à une fréquence ω, l'unité de détection (30) comprenant :

un générateur de signal (32) avec une première sortie permettant de générer un signal d'excitation (92) à une amplitude prédéfinie et à une fréquence proche de ω et d'appliquer le signal d'excitation (92) à la liaison de tension intermédiaire ;
une unité d'évaluation (34) permettant de déterminer un déphasage de la réponse de système au signal d'excitation (92) ; et
un comparateur (36) adapté pour comparer le déphasage déterminé par l'unité d'évaluation (34) avec une valeur attendue et adapté pour générer un signal d'avertissement (98) si le résultat est hors d'une plage admise.

13. Unité de détection (30) selon la revendication 12, dans laquelle le générateur de signal a une seconde sortie permettant de générer un second signal avec un angle de phase de 90 degrés par rapport au premier signal.

14. Unité de détection (30) selon la revendication 13, dans laquelle l'unité d'évaluation (34) effectue une corrélation orthogonale sur la réponse de système à l'aide du second signal.

15. Dispositif de liaison de tension intermédiaire (1) comportant un premier convertisseur (10), un second convertisseur (20) et une liaison de tension intermédiaire entre le premier convertisseur (10) et le second convertisseur (20), la liaison de tension intermédiaire ayant une fonction de transfert nominale affichant un saut de phase à une fréquence ω, comprenant une unité de détection (30) selon l'une quelconque des revendications 12 à 14, dans lequel au moins l'un des premier et second convertisseurs (10, 20) comprend une unité de commande de convertisseur (22) et l'unité de détection (30) fait partie de l'unité de commande de convertisseur (22).

16. Dispositif de liaison de tension intermédiaire (1) comportant un premier convertisseur (10), un second convertisseur (20) et une liaison de tension intermédiaire entre le premier convertisseur (10) et le second convertisseur (20), comprenant une unité de détection selon l'une quelconque des revendications 12 à 14, et notamment dispositif selon la revendication 15, où la liaison intermédiaire comprend une unité de hacheur de frein et l'unité de détection fait partie de l'unité de commande de hacheur de frein.

17. Dispositif de liaison de tension intermédiaire (1) comportant un premier convertisseur (10), un second convertisseur (20) et une liaison de tension intermédiaire entre le premier convertisseur (10) et le second convertisseur (20) comprenant une unité de détection selon l'une quelconque des revendications 12 à 14, et notamment dispositif selon la revendication 15 ou la revendication 16, dans lequel le premier convertisseur (10) est un convertisseur à quatre quadrants.

Fig. 1

Frequency

Fig. 2

Fig. 3

Fig. 4

Magnitude (dB)

Phase (deg);

20  0  -20  -40

100  50  0  -50  -100

C  B  A  D

35 Hz  48 Hz

Frequency (Hz)

Fig. 5

Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6134128 A
- EP 0826549 A1